Europäisches Patentamt

European Patent Office

Office européen des brevets

(11) Numéro de publication: **0 345 893**

**A1**

## (12) DEMANDE DE BREVET EUROPEEN

(21) Numéro de dépôt: **89201432.5**

(51) Int. Cl.⁴: **H03K 3/037 , H03K 3/356**

(22) Date de dépôt: **05.06.89**

(30) Priorité: **10.06.88 FR 8807780**

(43) Date de publication de la demande:
**13.12.89 Bulletin 89/50**

(84) Etats contractants désignés:
**CH DE FR GB IT LI**

(71) Demandeur: **Laboratoires d'Electronique et de Physique Appliquée L.E.P.**
**3, Avenue Descartes**
**F-94450 Limeil-Brévannes(FR)**

(84) **FR**

Demandeur: **N.V. Philips' Gloeilampenfabrieken**
**Groenewoudseweg 1**
**NL-5621 BA Eindhoven(NL)**

(84) **CH DE GB IT LI**

(72) Inventeur: **Gabillard, Bertrand Société Civile S.P.I.D.**
**209 rue de l'Université**
**F-75007 Paris(FR)**
Inventeur: **Rocchi, Marc Société Civile S.P.I.D.**
**209 rue de l'Université**
**F-75007 Paris(FR)**

(74) Mandataire: **Landousy, Christian et al Société Civile S.P.I.D. 209, Rue de l'Université**
**F-75007 Paris(FR)**

(54) **Circuit semiconducteur intégré comprenant un circuit diviseur de fréquences par deux.**

(57) Circuit semiconducteur intégré, comprenant un circuit diviseur de fréquences par deux, le circuit diviseur comprenant une boucle, laquelle comporte un étage inverseur A, un étage suiveur B et un canal d'un transistor monté en interrupteur et commandé par un signal de contrôle, caractérisé en ce que la boucle ne comporte qu'un canal d'un seul transistor monté en interrupteur $T_1$, le signal de contrôle étant un signal d'entrée H à la fréquence à diviser, le circuit diviseur utilisant la somme des retards de propagation desdits étages et du seul transistor monté en interrupteur.

FIG. 1a

# CIRCUIT SEMICONDUCTEUR INTEGRE COMPRENANT UN CIRCUIT DIVISEUR DE FREQUENCES PAR DEUX"

L'invention concerne un circuit semiconducteur intégré, comprenant un circuit diviseur de fréquences par deux, le circuit diviseur comprenant une boucle, laquelle comporte un étage inverseur A, un étage suiveur B et un canal d'un transistor monté en interrupteur et commandé par un signal de contrôle.

L'invention trouve son application dans la réalisation de circuits hyperfréquences, intégrés, numériques sur arséniure de gallium, notamment des sources de fréquence stabilisée ou des diviseurs programmables permettant de synthétiser un ensemble de fréquences stabilisées.

Il est généralement connu de l'état de la technique qu'un circuit diviseur de fréquences par deux réalisé en mode dynamique utilise moins de composants actifs et que le temps de propagation (Tpd) d'une porte est moindre comparé à un tel circuit fonctionnant en statique.

On peut à ce sujet comparer le circuit diviseur décrit dans "26GHz GaAs Room-Temperature Dynamic Divider circuit" by J.F. Jensen, L.G. Salmon et alii dans "GaAs IC Symposium pp.201-204" références CH2506-4·87 0000-0201-C-1987 IEEE, avec le circuit décrit dans "UltrahighSpeed GaAS Static Frequency Dividers" par J.F. Jensen, L.G. Salmon et alii dans "IEDM 86 pp.476-479" références CH 2381-2/86/0000-0476-C-1986 IEEE.

Le premier des deux documents cités décrit un circuit diviseur de fréquences par deux fonctionnant en dynamique, fondé sur l'utilisation de transistors à effet de champ à déplétion montrant une tension de pincement d'environ -2,5 V. Le diviseur est composé de deux étages (voir la figure 5 du premier document cité).

Le premier étage est formé d'un transistor interrupteur commandé par le premier signal d'horloge $\phi$, suivi d'une porte inverseuse de type BFL (d'ailleurs décrite sur la figure 4 du second document cité). Le second étage est formé d'un transistor interrupteur commandé par le second signal d'horloge $\bar{\phi}$ complémentaire suivi d'une porte suiveuse.

Les états logiques sont stockés en chargeant ou en déchargeant les capacités de grille des transistors inverseurs et suiveurs.

La vitesse du circuit est limitée par le temps de propagation des deux portes (2 Tpd).

Ce circuit diviseur dynamique connu présente évidemment l'avantage d'être réalisable au moyen d'un nombre de transistors considérablement moins grand que le circuit diviseur décrit dans le second document, et de présenter un temps de propagation par porte (Tpd) plus faible. Il en résulte une consommation plus faible, une aptitude à l'intégration à grande échelle plus élevée, et une fréquence maximale de fonctionnement plus élevée.

Cependant, si le circuit décrit dans le premier document cité présente un certain nombre d'avantages, il n'en présente pas moins, dans un domaine de la technique où il est recherché de réaliser des circuits toujours plus performants, encore un certain nombre d'inconvénients.

Notamment la fréquence maximale est limitée par les deux temps de propagation de portes :

$F_{max} \simeq 1 (2 Tpd)$.

D'autre part, ce circuit comprend deux transistors interrupteurs commandés chacun par deux signaux d'horloge complémentaires.

La difficulté vient alors du fait que :
- ou bien ces deux signaux d'horloges complémentaires doivent être fournis par un circuit extérieur,
- ou bien ils doivent être générés dans le circuit lui-même.

Dans l'un comme dans l'autre cas, se pose le problème de générer deux signaux d'horloge rigoureusement complémentaires à des fréquences aussi élevées que celles du domaine envisagé par la présente invention, c'est-à-dire environ 20 GHz.

La présente invention propose donc un circuit diviseur de fréquences par deux :
- qui ne nécessite l'utilisation que d'un seul signal d'horloge,
- qui présente un moins grand nombre de transistors et donc une densité d'intégration plus grande et ceci même sans tenir compte de la suppression du circuit nécessaire à la génération d'une horloge complémentaire,
- qui présente une fréquence maximale deux fois plus élevée que selon l'art antérieur si on utilise la même technologie.

Il faudra noter cependant que le domaine d'utilisation du circuit selon l'invention où le principal effet recherché est l'augmentation de la fréquence maximale de fonctionnement, se verra en revanche limitée à un octave, ce qui n'est pas un inconvénient pour les applications quasi-analogiques de ces circuits numériques. En effet la fréquence d'entrée sera :

$f_{Max}/2 < f < f_{Max}$

avec $f_{Max} = 1/(1\ Tpd)$ et un FAN-OUT $\simeq 1$ (ce qui était aussi le cas du circuit connu).

Selon l'invention, ces buts sont atteints au moyen d'un circuit tel que défini dans le préambule de la revendication 1, en outre caractérisé en ce que la boucle ne comporte qu'un canal d'un seul transistor monté en interrupteur $T_1$, le signal de contrôle étant un signal d'entrée H à la fréquence à diviser, le circuit diviseur utilisant la somme des retards de propagation desdits étages et du seul transistor monté en interrupteur. La coopération de l'interruption du transistor monté en interrupteur et des retards de propagation permet au circuit diviseur de fonctionner proprement sous certaines conditions. Ce circuit se comporte comme un oscillateur en anneau.

Dans une forme de réalisation le circuit semiconducteur intégré est caractérisé en ce que le circuit diviseur est réalisé en technologie du type BFL sur arséniure de gallium, comprenant des transistors du type MESFET ou du type HFET (Heterostructure FET). Les circuits en arséniure de gallium du type BFL sont considérés comme les plus rapides. En outre les transistors du type HFET sont très rapides du faitd'une très haute mobilité des électrons. C'est pour atteindre les fréquences les plus élevées que le circuit diviseur est réalisé de préférence en technologie BFL sur arséniure de gallium, en utilisant des transistors du type HFET.

L'invention sera mieux comprise au moyen de la description suivante illustrée par les figures annexées dont :

- la figure 1a représente schématiquement un exemple du circuit selon l'invention ;
- la figure 1b représente le même circuit au moyen de blocs fonctionnels ;
- la figure 2 représente le séquencement des signaux se propageant dans le circuit ;
- la figure 3 représente les signaux hyperfréquences d'entrée en traits discontinus et de sortie en trait plein.

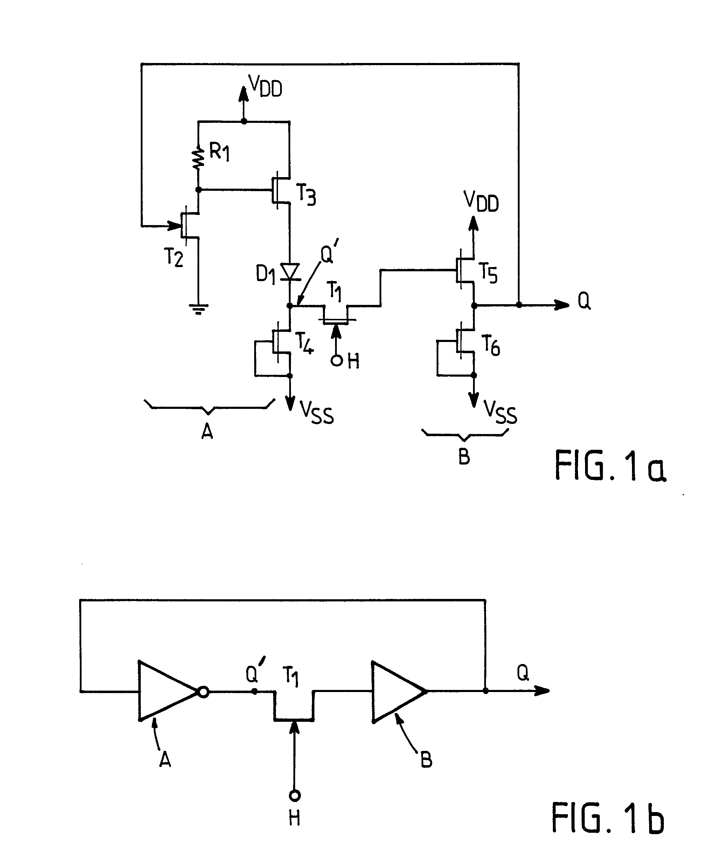

Un exemple du circuit selon l'invention est représenté de façon schématique sur la figure 1a.

Il est réalisé de préférence au moyen de transistors à effet de champ MESFET du type à déplétion de charges, ou de transistors HFET (FET à hétérostructure) du type à désertion de charges, dont la tension de pincement :

$V_T \simeq -0,6\ V$

Cette valeur de la tension de pincement, qui est faible devant celle des transistors utilisés pour réaliser le circuit connu de l'état de la technique, est spécialement choisie pour obtenir une excursion logique faible et augmenter encore la fréquence maximale de fonctionnement.

De plus, en utilisant des transistors dont la tension de pincement est de l'ordre de -0,6 V, une seule diode $D_1$ est suffisante pour assurer la translation de niveau dans l'étage inverseur A, comme indiqué ci-dessous.

Ainsi tel que représenté sur les figure 1a et 1b, le circuit selon l'invention comprend un premier étage A constitué d'une porte inverseuse du type BFL à une diode $D_1$, et un second étage B constitué par une porte suiveuse, isolée de la porte inverseuse par un transistor interrupteur $T_1$.

Le transistor interrupteur $T_1$ est commandé par l'unique signal d'entrée H de fréquence $f_e$ qui sera divisée par deux par le circuit.

La porte inverseuse A est constituée d'un transistor $T_2$ dont le drain est porté à l'alimentation continue $V_{DD}$ à travers une résistance $R_1$, et dont la source est reliée à la masse. Un transistor monté en grille et source communes peut remplacer cette résistance.

La porte inverseuse comprend en outre un étage translateur de niveau constitué du transistor $T_3$ dont le drain est relié à l'alimentation continue $V_{DD}$, dont la grille reçoit le signal inversé disponible sur le drain de $T_2$, et dont la source est reliée à travers la diode $D_1$ au transistor source de courant $T_4$, monté en grille et source communes à une seconde tension continue $V_{SS}$.

Le transistor interrupteur $T_1$ est monté entre le point commun de la diode $D_1$ et du transistor $T_4$, et la grille du transistor haut $T_5$ de l'étage suiveur B.

Cet étage suiveur B est constitué du transistor $T_5$ dont le drain est porté à l'alimentation $V_{DD}$ et dont la source est reliée à un transistor source de courant $T_6$, ce transistor $T_6$ étant tel que sa grille et sa source sont communes à la seconde alimentation $V_{SS}$. Le signal de sortie Q du diviseur est disponible au point commun des transistors $T_5$ et $T_6$ de l'étage B, et est reporté sur la grille du transistor inverseur $T_2$.

Les dimensions des transistors et diode sont données dans le tableau I.

Notamment les largeurs de grilles des transistors $T_2$, $T_3$, $T_4$, $T_5$, $T_6$ sont identiques. La largeur de grille du transistor interrupteur $T_1$ est moitié de celle des transistors précédents.

Les niveaux hauts et bas du signal d'entrée H sont donnés par les relations du tableau II, dans lesquelles :

EP 0 345 893 A1

(V$_H$)bas est la tension correspondant à l'état bas du signal d'entrée H.

(V$_H$)haut est la tension correspondant à l'état haut du signal d'entrée H.

(V$_Q'$)bas est la tension correspondant à l'état bas du signal Q' présent au point commun entre la sortie de l'inverseur A et le transistor T$_1$ (voir schéma fonctionnel de la figure 1b).

(V$_Q'$)haut est la tension correspondant à l'état haut du signal Q' au point défini précédemment.

Le schéma fonctionnel de la figure 1b montre par ailleurs la porte A inverseuse, le transistor T$_1$ interrupteur commandé par le signal d'entrée H, la porte B suiveuse qui fournit en sortie le signal de sortie Q de fréquence moitié de celle du signal H, ce signal Q étant reporté à l'entrée de la porte inverseuse A.

Le type de diviseur selon l'invention se comporte comme un oscillateur en anneau synchronisé par le signal d'entrée ou horloge H qui commande le transistor interrupteur T$_1$.

La plage de fréquences utilisables dépend du rapport cyclique du signal d'entrée.

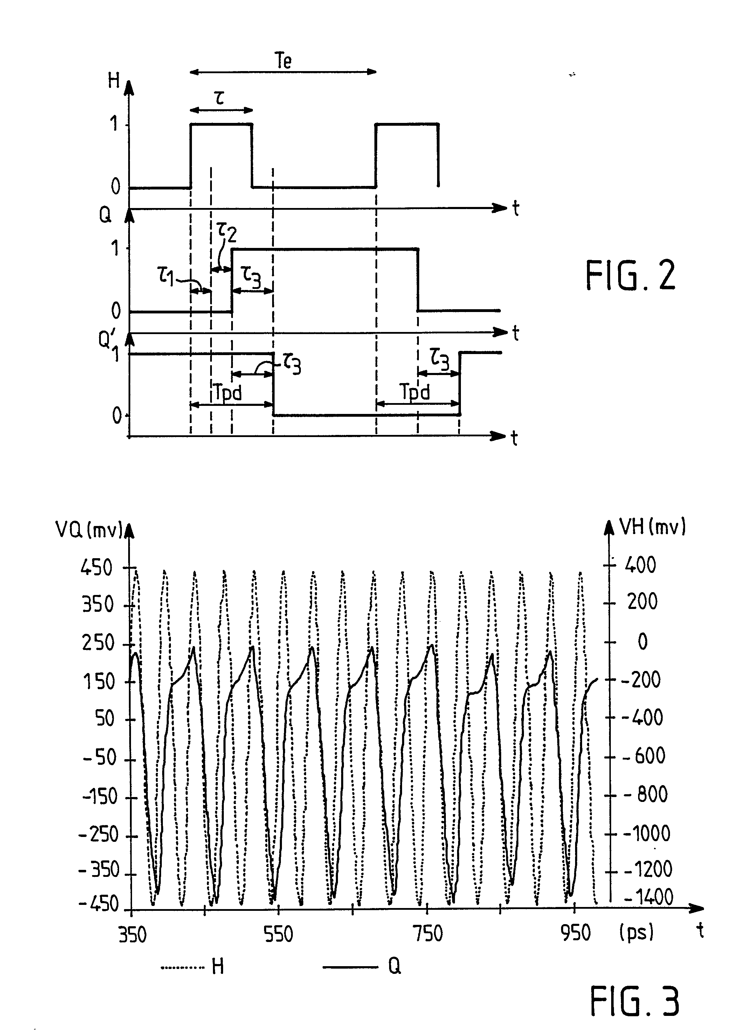

Le chronogramme de la figure 2 montre le séquencement des signaux dans un exemple où le signal d'entrée H serait un signal carré avec :

$$\tau_1 = \text{temps de propagation dans } T_1$$

$$\tau_2 = \text{"} \quad \text{"} \quad \text{"} \quad \text{" dans B}$$
$$\tau_3 = \text{"} \quad \text{"} \quad \text{"} \quad \text{" dans A}$$

Temps de propagation total pour faire un cycle

Tpd = $\tau_1 + \tau_2 + \tau_3$

(voir la figure 1b).

Tel que représenté sur la figure 2,

$\tau$ est le temps de fermeture de l'interrupteur T$_1$, c'est-à-dire le temps où le signal d'entré H est à l'état haut (V$_H$ = 1) et où le transistor T$_1$ est un court-circuit.

Si l'interrupteur T$_1$ est fermé (en court-circuit) pendant un temps

$\tau \leq$ Tpd

alors le circuit selon l'invention se comporte bien comme un diviseur de fréquences par deux. Ceci est obtenu, si les conditions du tableau III sont respectées.

La figure 3 montre la courbe représentative en trait plein du signal de sortie dont l'amplitude est portée en ordonnée en mV, en fonction du temps t en ps.

La fréquence de ce signal est de 12,5 GHz qui est bien divisée par deux vis-à-vis de la fréquence du signal d'entrée représenté sur la même figure en traits discontinus, fréquence d'entrée qui est de 25 GHz.

Les niveaux du signal d'entrée H vont de -1,4 V à +0,4 V. Les niveaux du signal de sortie Q vont de : -0,45 V à +0,25 V.

La puissance consommée est de l'ordre de 40 mW.

Pour permettre de reporter le signal de sortie Q sur un étage ultérieur d'impédance d'entrée telle que 50 Ω, un étage tampon (buffer) peut par exemple être interposé entre la sortie Q et ledit étage ultérieur, de toute manière connue en soi de l'homme du métier.

4

**TABLEAU I**

$V_{DD}$ = 1,5 à 2 V

$V_{SS}$ = -2 V à -3 V

$V_T$ = -0,6 à -1 V

L = largeur de grille des transistors ou diodes

ℓ = longueur de grille des transistors = 0,5 µm

$R_1$ = 500 Ω

================================================================

| Transistors | L |
|---|---|
| $T_2$, $T_3$, $T_4$, $T_5$, $T_6$, $D_1$ | 30 µm |
| $T_1$ | 15 µm |

**TABLEAU II**

$(V_H)$Bas < $(V_{Q'})$Bas + $V_T$ pour bloquer $T_1$

$(V_H)$Haut < $(V_{Q'})$Bas + 0,7 V (où 0,7 V est la tension d'écrêtage de la diode $D_1$)

$(V_H)$Haut > $(V_{Q'})$Haut + $V_T$

Avec les conditions du tableau I

$(V_{Q'})$Bas ≃ -0,4 V

$(V_{Q'})$Haut ≃ 0,25 V

$V_T$ ≃ -0,6 V

On en déduit les conditions de fonctionnement du circuit

$(V_H)$Bas < -1,2 V

-0,35 V < $(V_H)$Haut < 0,3 V

| TABLEAU III |
|---|
| $\tau > \tau_1$<br><br>$\tau < Tpd$<br><br>**Tpd < T qui est la période du signal d'entrée H de**<br><br>**fréquence $f_e$**<br><br>On définit le rapport cyclique<br><br>$\alpha = (T - \tau)/\tau$<br><br>Les conditions de fonctionnement s'expriment alors par<br><br>$\tau_1 < \tau = T/(\alpha + 1) < Tpd$<br><br>et $1/[(\alpha+1)Tpd] < f_e < 1/[(\alpha + 1) \tau_1]$<br><br>$\qquad f_e < 1/Tpd$<br><br>Si $\alpha = 1$, alors :<br><br>$1/2Tpd < f < 1/Tpd < 1/2 \tau_1$<br><br>en effet $\tau_1 < \tau_3$ car le temps de propagation à<br><br>travers l'interrupteur $T_1$ est très faible, ce qui<br><br>entraîne :<br><br>$\tau_1 < (\tau_1 + \tau_2 + \tau_3)/2 = Tpd/2$ |

**Revendications**

1. Circuit semiconducteur intégré, comprenant un circuit diviseur de fréquences par deux, le circuit diviseur comprenant une boucle, laquelle comporte un étage inverseur A, un étage suiveur B et un canal d'un transistor monté en interrupteur et commandé par un signal de contrôle, caractérisé en ce que la boucle ne comporte qu'un canal d'un seul transistor monté en interrupteur $T_1$, le signal de contrôle étant un signal d'entrée H à la fréquence à diviser, le circuit diviseur utilisant la somme des retards de propagation desdits étages et du seul transistor monté en interrupteur.

2. Circuit semiconducteur intégré selon la revendication 1, caractérisé en ce que le circuit diviseur est réalisé en technologie du type BFL.

3. Circuit semiconducteur intégré selon la revendication 1, caractérisé en ce que le circuit diviseur est réalisé en technologie du type BFL sur arséniure de gallium, comprenant des transistors du type MESFET ou du type HFET.

4. Circuit semiconducteur intégré selon l'une des revendications 2 ou 3, caractérisé en ce que l'étage inverseur A comprend un transistor inverseur $T_2$ dont la source est reliée à la masse, dont le drain est porté à une alimentation $V_{DD}$ à travers une première source de courant $R_1$, et dont la grille est couplée à une sortie de l'étage suiveur B rebouclée, l'étage inverseur A comprend en outre un étage translateur comprenant un premier transistor translateur $T_3$, dont la grille est couplée à un premier noeud commun au transistor inverseur $T_2$ et à la première source de courant $R_1$, dont le drain est porté à l'alimentation $V_{DD}$, et dont la source est reliée à une seconde source de courant à travers au moins une diode $D_1$, un second noeud entre la diode $D_1$ et la seconde source de courant étant la sortie $Q'$ de l'étage inverseur A.

5. Circuit semiconducteur intégré selon l'une des revendications 2, 3 ou 4, caractérisé en ce que l'étage suiveur B comprend un transistor suiveur $T_5$, dont le drain est porté à une alimentation $V_{DD}$, dont la source est reliée à une troisième source de courant $T_6$, la source du transistor suiveur $T_5$ étant la sortie de l'étage suiveur B, et dont la grille est reliée à la sortie de l'étage inverseur A.

6. Circuit semiconducteur intégré selon l'une des revendications 4 ou 5, caractérisé en ce que chacune desditessources de courant comprend une résistance ou un transistor monté en grille et source communes, la seconde et troisième source de courant étant reliées à une seconde alimentation $V_{SS}$.

FIG.1a

FIG.1b

1-Ⅱ-PHF 88-547

FIG. 2

FIG. 3

2-II-PHF 88-547

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| X | ELECTRONICS LETTERS vol. 17, no. 4, 19 février 1981, pages 168,169, London, GB; M. ROCCHI et al.:"GaAs binary frequency dividers for high speed applications up to 10 GHz"* figure 2A, figure 1 en particulier * | 1-3 | H 03 K 3/037 H 03 K 3/356 |
| A | idem --- | 4,6 | |
| X | IEEE JOURNAL OF SOLID-STATE CIRCUITS vol. SC-18, no. 3, juin 1983, pages 369-376, New York, US; M. ROCCHI et al.:"GaAs digital dynamic IC's for applications up to 10 GHz" * figures 6,3A, figure 5 en particulier; paragraphes II,III,IV * | 1-3 | |
| A | idem --- | 4,6 | |
| A,D | Ga As IC SYMPOSIUM références CH2506-4/870000-0201-C-1987 IEEE, pages 201-204; J.F. JENSEN et al.:"26-GHz GaAs room-temperature dynamic divider circuit" * figure 5 * --- | 1-6 | DOMAINES TECHNIQUES RECHERCHES (Int. Cl.4) |
| A,D | Ga As IC SYMPOSIUM références CH 2381-2/86/0000-0476-C-1986 IEEE, pages 476-479; J.F. JENSEN et al.:"Ultrahigh-speed GaAs static frequency dividers" ----- | 1 | H 03 K 3/037 H 03 K 3/356 H 03 K 19/094 H 03 K 23/00 H 03 K 23/58 H 03 K 23/60 |

Le présent rapport a été établi pour toutes les revendications

| Lieu de la recherche | Date d'achèvement de la recherche | Examinateur |
|---|---|---|
| BERLIN | 20-07-1989 | ARENDT M |